# EUROPEAN PATENT APPLICATION

(11) **EP 3 968 301 A1**
(43) Date of publication of application: **16.03.2022**
(21) Application number: 21786312.5
(22) Date of filing: 12.07.2021
(51) Int. Cl.: G08C 17/02, G01D 5/14, G01D 11/24, G01D 5/39, G01D 11/30, G01D 5/243

(54) **INDUSTRIAL WIRELESS SENSOR SYSTEM**

(30) Priority: 13.07.2020 KR 20200085868
(71) Applicant: Sun HST Co., Ltd., Ulsan 44495 (KR)
(72) Inventor: LEE, Jin Yong, Ulsan 44409 (KR)
(74) Representative: Frenkel, Matthias Alexander
(86) International application number: PCT/KR2021/008904
(87) International publication number: WO 2022/014993

(57) **Abstract**

Embodiments of the present invention relate to an industrial wireless sensor system and aim to provide an industrial wireless sensor system in which three types of sensors (e.g., magnetic field detection sensor, limit sensor, proximity sensor), which are conventionally provided only as wired sensors, are replaced with wireless sensors. To that end, according to the present invention, there is disclosed an industrial wireless sensor system, comprising a sensor sensing an external physical state and outputting a sensing signal, a sensor controller converting the sensing signal from the sensor, converting the sensing signal into a digital signal, and outputting the digital signal, a wireless communication unit receiving the digital signal from the sensor controller, converting the digital signal into a wireless signal, and outputting the wireless signal to a factory controller, a power source supplying power to each of the sensor and the sensor controller, and a battery connected to the power source.

## Description

### Technical Field

Embodiments of the present invention relate to industrial wireless sensor systems.

### Background Art

Examples of sensors mainly used in automobile body production lines include magnetic field sensors that detect the positions of pneumatic cylinders, limit sensors that detect the movement of bogies, and proximity sensors that detect work panels. Such sensors are provided only as wired sensors and require a number of wires to be connected manually one by one in manufacturing production facilities, and materials and space are needed to organize the wires.

Most of conventional wireless sensors are environment-related sensors which detect, e.g., temperature, humidity, or gas, and such a wireless sensor is composed of a wired sensor and a wireless transceiver mounted on the wired sensor.

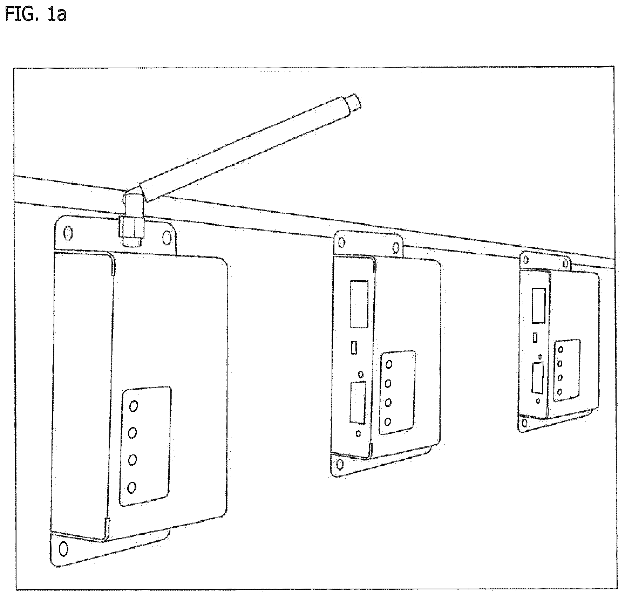

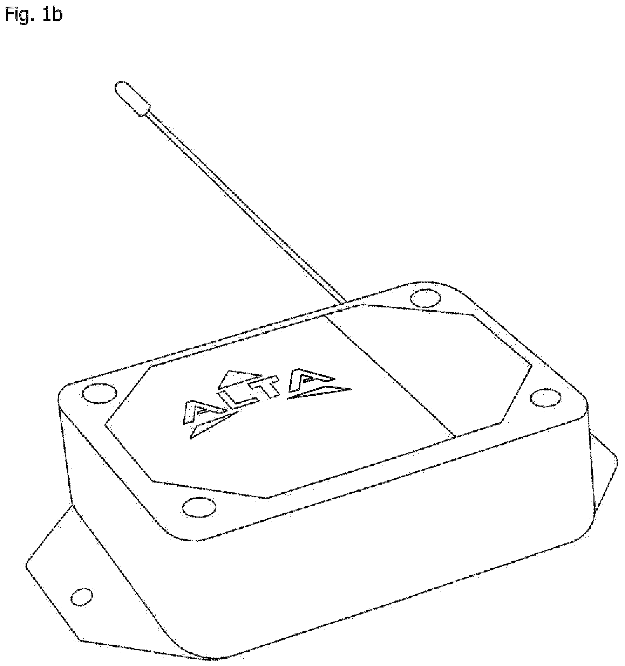

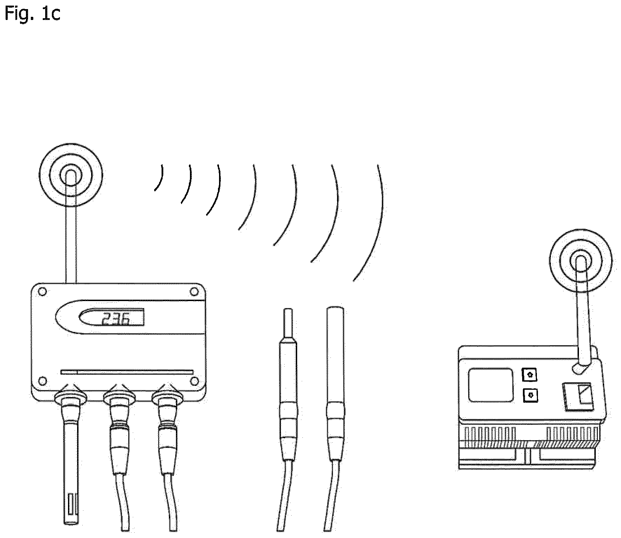

FIGS. 1A to 1F are views illustrating an industrial wireless sensor system according to the prior art. FIG. 1A illustrates a conventional wireless temperature/humidity sensor, and FIG. 1B illustrates a conventional wireless vibration sensor. As illustrated in FIG. 1C, a wireless transmitter is mounted on a wired sensor.

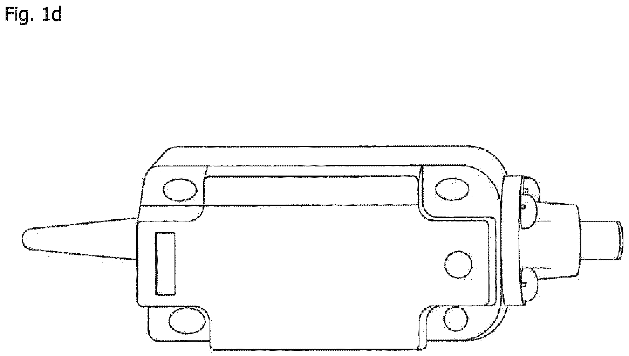

FIG. 1D illustrates a wireless limit switch according to the prior art. This conventional wireless limit switch lacks a battery and generates its own electric power and performs communication only at the moment of detection. However, this has a drawback that it cannot be used in a place where it is necessary to receive and monitor sensor values in real time.

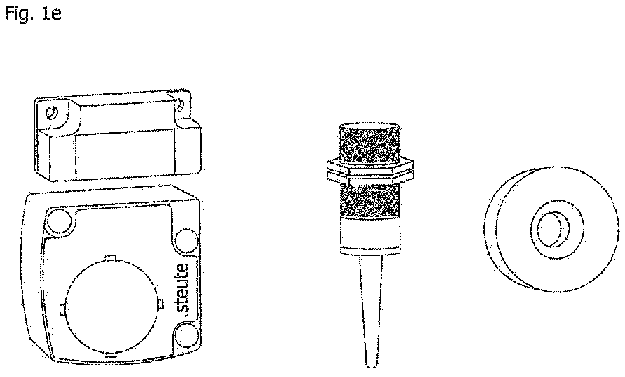

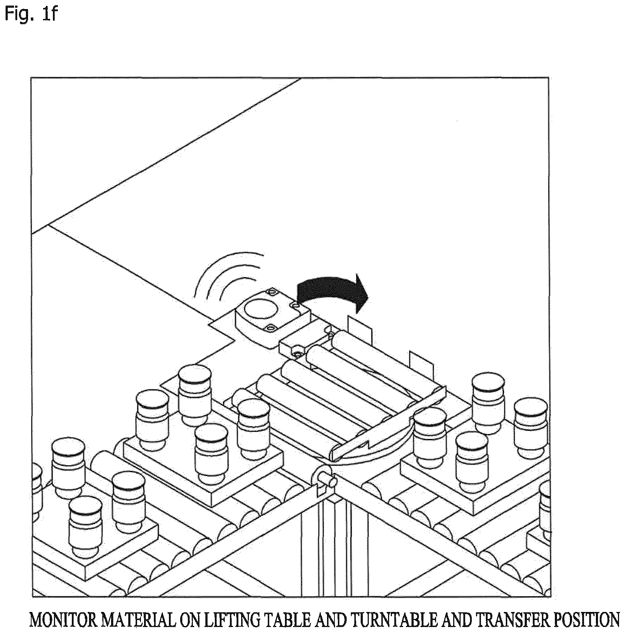

FIG. 1E illustrates an industrial wireless magnetic sensor according to the prior art. This conventional wireless magnetic sensor is composed of a magnetic sensor that detects magnetic force and an actuator. Here, the actuator has magnetism. The actuator is fixed to a lifting table or turntable and, if the actuator moves with the table, the magnetic sensor detects the movement. In other words, as illustrated in FIG. 1F, the wireless magnetic sensor monitors the material on the lifting table and the turn table and transfers the position.

The description disclosed in the Background section is only for a better understanding of the background of the invention and may also include information which does not constitute the prior art.

### Detailed Description of the Invention

### Technical Problems

An object of embodiments of the present invention is to provide an industrial wireless sensor system in which three types of sensors (e.g., magnetic field detection sensor, limit sensor, proximity sensor), which are conventionally provided only as wired sensors, are replaced with wireless sensors.

### Means to Address the Problems

According to embodiments of the present invention, an industrial wireless sensor system comprises a sensor sensing an external physical state and outputting a sensing signal, a sensor controller converting the sensing signal from the sensor, converting the sensing signal into a digital signal, and outputting the digital signal, a wireless communication unit receiving the digital signal from the sensor controller, converting the digital signal into a wireless signal, and outputting the wireless signal to a factory controller, a power source supplying power to each of the sensor and the sensor controller, and a battery connected to the power source.

The sensor includes at least one of a wireless magnetic field sensor, a wireless limit sensor, and a wireless proximity sensor.

The wireless magnetic field sensor includes a Hall sensor. An analog value of the Hall sensor is input to an analog-to-digital converter port of the sensor controller.

The wireless magnetic field sensor is attached to a cylinder.

The wireless limit sensor includes a micro detection switch. A switching signal of the micro detection switch by a push lever is input to the sensor controller.

The wireless limit sensor is attached to a jig on which a panel is seated or a rail on which a jig bogie moves.

The wireless proximity sensor includes a high frequency oscillation circuit. A signal from the high frequency oscillation circuit by approach of a metallic object is input to the sensor controller.

The wireless proximity sensor is attached to a clamp on which a panel is seated.

The industrial wireless sensor system performs a step in which the sensor controller transmits, to the factory controller, information for a time to start initial transmission of periodic uplink transmission by the sensor controller, a step in which the sensor controller receives a configuration indicating periodic uplink resource allocation from the factory controller, a step in which the sensor controller transmits a periodic uplink to the factory controller based on the periodic uplink resource allocation, and a step of transmitting a sensor failure signal to a factory network if a response signal received by the factory controller from the sensor controller is not matched as compared with a command transmitted to the sensor controller by the factory controller or if no response signal is received.

### Effects of the Invention

Embodiments of the present invention provide an industrial wireless sensor system in which three types of sensors (e.g., magnetic field detection sensor, limit sensor, proximity sensor), which are conventionally provided only as wired sensors, are replaced with wireless sensors. Further, embodiments of the present invention may significantly reduce the time and costs of wiring work and allow for quick and easy diagnosis and treatment in equipment maintenance.

### Brief Description of the Drawings

FIGS. 1A to 1F are views illustrating an industrial wireless sensor system according to the prior art.
FIG. 2 is a block diagram illustrating a configuration of an industrial wireless sensor system according to an embodiment of the present invention.
FIGS. 3A and 3B and 4A to 4C are views illustrating an example of a wireless magnetic field sensor of an industrial wireless sensor system according to an embodiment of the present invention.
FIGS. 5A to 5C and 6 are views illustrating an example of a wireless limit sensor of an industrial wireless sensor system according to an embodiment of the present invention.
FIGS. 7, 8A, 8B, and 9 are views illustrating an example of a wireless proximity sensor of an industrial wireless sensor system according to an embodiment of the present invention.
FIG. 10 is a block diagram illustrating a configuration of an industrial wireless sensor system in a factory according to an embodiment of the present invention.
FIG. 11 is a view illustrating a wireless signal transmission/reception and cycle period between a wireless sensor, a factory controller, and a factory network in an industrial wireless sensor system according to an embodiment of the present invention.
FIG. 12 is a flowchart illustrating a method for operating an industrial wireless sensor system according to embodiments of the present invention.

### Mode to Practice the Invention

Hereinafter, embodiments of the present invention are described in detail with reference to the accompanying drawings.

Embodiments of the disclosure are provided to thoroughly explain the disclosure to those skilled in the art, and various modifications may be made thereto, and the scope of the present invention is not limited thereto. Embodiments of the disclosure are provided to fully and thoroughly convey the spirit of the present invention to those skilled in the art.

As used herein, the thickness and size of each layer may be exaggerated for ease or clarity of description. The same reference denotations may be used to refer to the same or substantially the same elements throughout the specification and the drawings. As used herein, the term "A and/or B" encompasses any, or one or more combinations, of A and B. It will be understood that when an element or layer is referred to as being "on," "connected to," "coupled to," or "adjacent to" another element or layer, it can be directly on, connected, coupled, or adjacent to the other element or layer, or intervening elements or layers may be present.

The terms as used herein are provided merely to describe some embodiments thereof, but not intended as limiting the present invention. As used herein, the singular forms "a," "an," and "the" are intended to include the plural forms as well, unless the context clearly indicates otherwise. As used herein, the term "comprise," "include," and/or "comprising" or "including" does not exclude the presence or addition of one or more other components, steps, operations, and/or elements than the component, step, operation, and/or element already mentioned.

As used herein, the terms "first" and "second" may be used to describe various members, parts, regions, areas, layers, and/or portions, but the members, parts, regions, areas, layers, and/or portions are not limited thereby. These terms are used merely to distinguish one member, part, region, area, layer, or portion from another. Accordingly, the term "first member," "first part," "first region," "first area," "first layer," or "first portion" described herein may denote a "second member," "second part," "second region," "second area," "second layer," or "second portion" without departing from the teachings disclosed herein.

The terms "beneath," "below," "lower," "under," "above," "upper," "on," or other terms to indicate a position or location may be used for a better understanding of the relation between an element or feature and another as shown in the drawings. However, embodiments of the present invention are not limited thereby or thereto. For example, where a lower element or an element positioned under another element is overturned, then the element may be termed as an upper element or element positioned above the other element. Thus, the term "under" or "beneath" may encompass, in meaning, the term "above" or "over."

As described herein, the controller and/or other related devices or parts may be implemented in hardware, firmware, application specific integrated circuits (ASICs), software, or a combination thereof. For example, the controller and/or other related devices or parts or its or their components may be implemented in a single integrated circuit (IC) chip or individually in multiple IC chips. Further, various components of the controller may be implemented on a flexible printed circuit board, in a tape carrier package, on a printed circuit board, or on the same substrate as the controller. Further, various components of the controller may be processes, threads, operations, instructions, or commands executed on one or more processors in one or more computing devices, which may execute computer programming instructions or commands to perform various functions described herein and interwork with other components. The computer programming instructions or commands may be stored in a memory to be executable on a computing device using a standard memory device, e.g., a random access memory (RAM). The computer programming instructions or commands may be stored in, e.g., a compact-disc read only memory (CD-ROM), flash drive, or other non-transitory computer readable media. It will be appreciated by one of ordinary skill in the art that various functions of the computing device may be combined together or into a single computing device or particular functions of a computing device may be distributed to one or other computing devices without departing from the scope of the present invention.

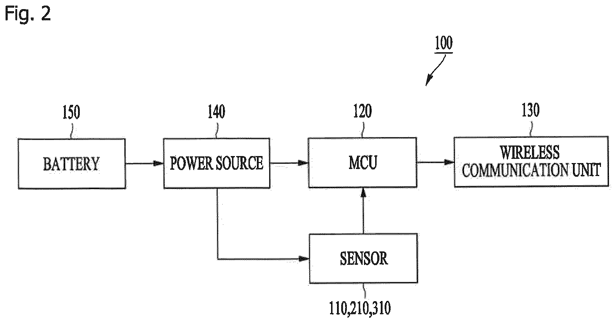

FIG. 2 is a block diagram illustrating a configuration of an industrial wireless sensor system 100 according to an embodiment of the present invention.

As illustrated in FIG. 2, the industrial wireless sensor system 100 according to an embodiment of the present invention may include sensors 110, 210, and 310, a sensor controller 120, a wireless communication unit 130, a power source 140, and a battery 150.

The sensors 110, 210, and 310 may sense an external physical state (e.g., magnetic field, position, proximity) and may output the sensed analog signal to the sensor controller 120. In some examples, the sensors 110, 210, and 310 may include a wireless magnetic field sensor 110, a wireless limit sensor 210, and/or a wireless proximity sensor 310. In some examples, the number of the sensors 110, 210, 310 may be several tens to several tens of thousands. The sensors 110, 210, and 310 are described again below.

The sensor controller 120 may receive an analog sensing signal from the sensors 110, 210, and 310, convert the analog sensing signal into a digital signal, and output the digital signal to the wireless communication unit 130. To that end, the sensor controller 120 may include a central processing unit and a memory. The memory may store an algorithm for the operation of the wireless sensor system 100 according to an embodiment of the present invention and various constants or variables.

The wireless communication unit 130 may receive the digital signal from the sensor controller 120, convert the digital signal into a wireless signal, and transmit the wireless signal to a factory controller (not shown). In some examples, the wireless communication unit 130 may receive a command from the factory controller and transfer the command to the sensor controller 120, or the wireless communication unit 130 may receive a response signal (i.e., a sensing signal) from the sensor controller 120 and transmit the response signal to the factory controller. In some examples, the wireless communication unit 130 may include a wireless antenna for transmitting and receiving wireless signals. in some examples, the wireless communication unit 130 of the industrial wireless sensor system 100 and a wireless communication unit of the factory controller each may include a Wi-Fi communication module of a 2.4 GHz band and/or a ZigBee communication module.

The power source 140 may supply a predetermined level of direct current (DC) power to the sensors 110, 210, and 310 and the sensor controller 120. The battery 150 is electrically connected with the power source 140 to supply power to the power source 140. The battery 150 may include a rechargeable battery 150. In some examples, the power source 140 may receive power from the battery 150 and/or an external DC power supply (not shown). Further, in some examples, the battery 150 may be charged through a charging module from a solar cell module and/or an external DC power supply.

Thus, embodiments of the present invention may provide an industrial wireless sensor system 100 in which three types of sensors (e.g., magnetic field sensor, limit sensor, and proximity sensor), which are conventionally provided only as wired sensors, are replaced with the wireless sensors 110, 210, and 310. Further, embodiments of the present invention may provide an industrial wireless sensor system 100 that may significantly reduce the time and costs of wiring work and allows for quick and easy diagnosis and treatment in equipment maintenance.

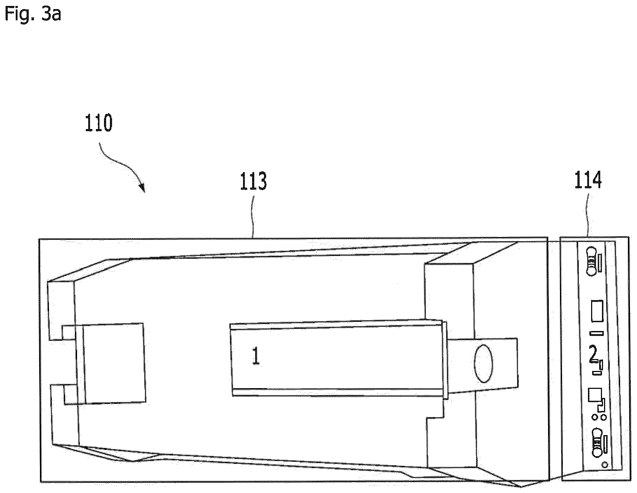

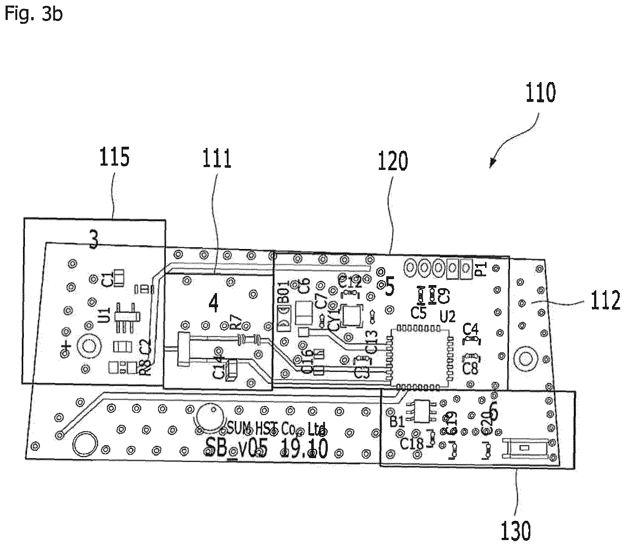

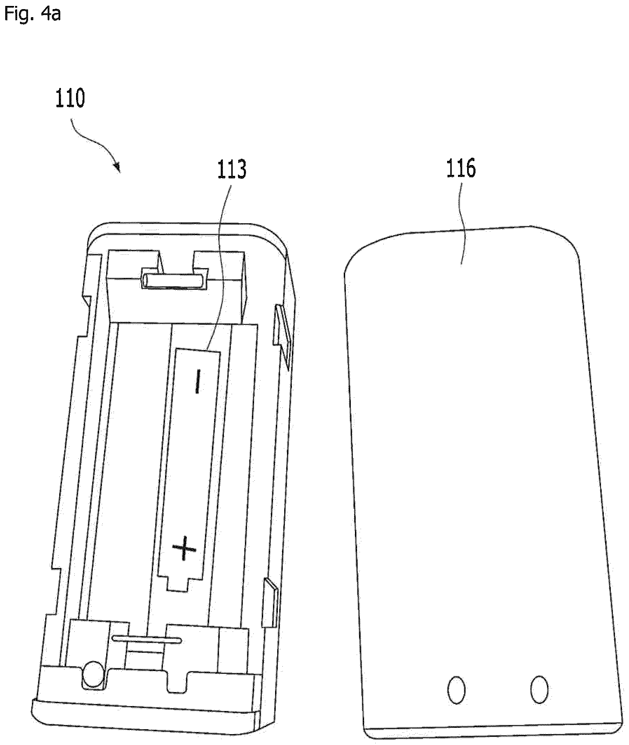

FIGS. 3A and 3B and 4A to 4C are views illustrating an example of a wireless magnetic field sensor 110 of an industrial wireless sensor system 100 according to an embodiment of the present invention,

In some examples, the wireless magnetic field sensor 110 may include a Hall sensor 111, and an analog value of the Hall sensor 111 may be input to an analog-to-digital converter port of the sensor controller 120.

FIG. 3A illustrates that a battery holder 113 and a detection status display LED (green/yellow) 114 provided on an upper surface of a printed circuit board 112, and FIG. 3B illustrates that a direct current (DC) input/output LDO regulator 115, a Hall sensor 111 (which outputs an analog value), a sensor controller 120 (e.g., an MCU), and a wireless communication unit 130 (e.g., a 2.4GHz chip antenna module) on a lower surface of the printed circuit board 112.

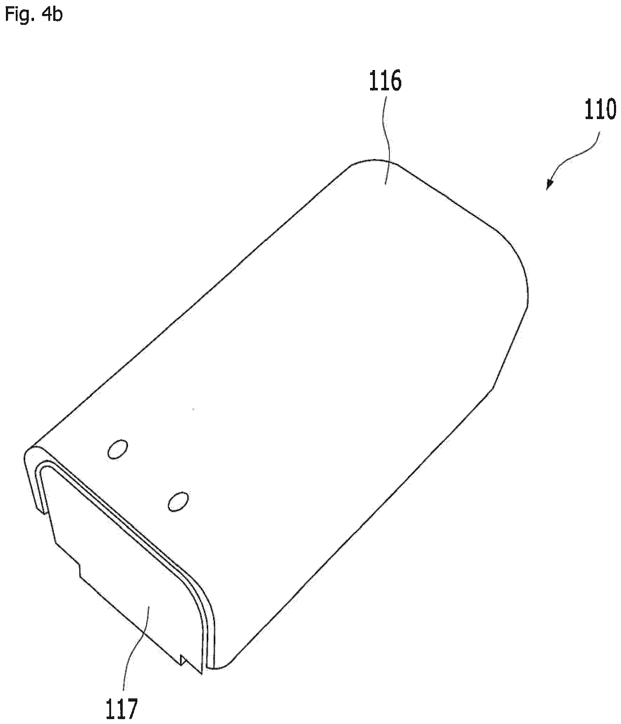

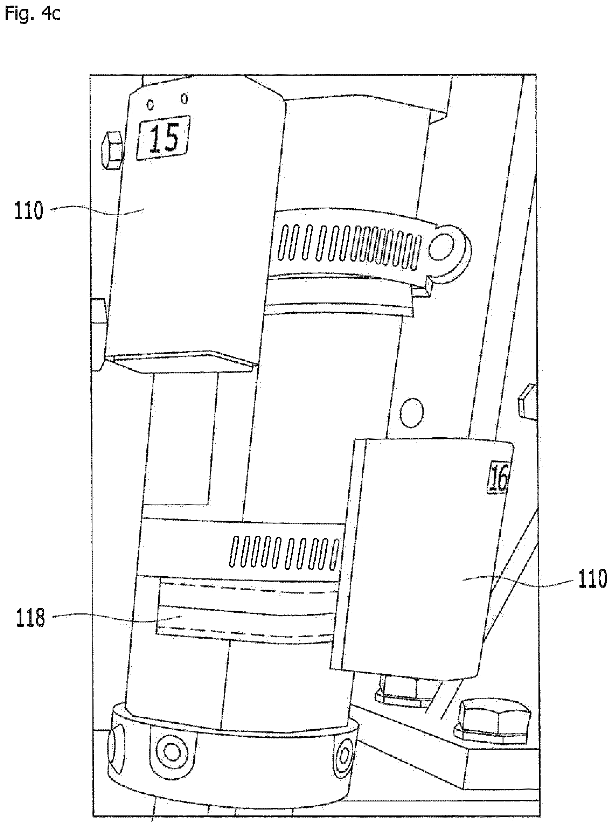

Further, FIG. 4A illustrates an assembled state of the printed circuit board 112 to a lower case 116, FIG. 4B illustrates an assembled state of the lower case 116 and an upper case 117, and FIG. 4C illustrates a wireless magnetic field sensor 110 attached to a cylinder 118.

In general, a wireless magnetic field sensor includes a magnetic sensor that detects magnetic force and an actuator that has magnetism. The actuator is fixed to a lifting table or a turntable and, if the actuator moves together with the table, the magnetic sensor detects the movement. However, the wireless magnetic field sensor 110 according to an embodiment of the present invention is identical to the conventional magnetic sensor in that it detects magnetism but differs from the conventional magnetic sensor in where it is used. In other words, the wireless magnetic field sensor 110 according to an embodiment of the present invention is dedicated to a cylinder, as attached to a pneumatic cylinder 118 to grasp the position of the cylinder.

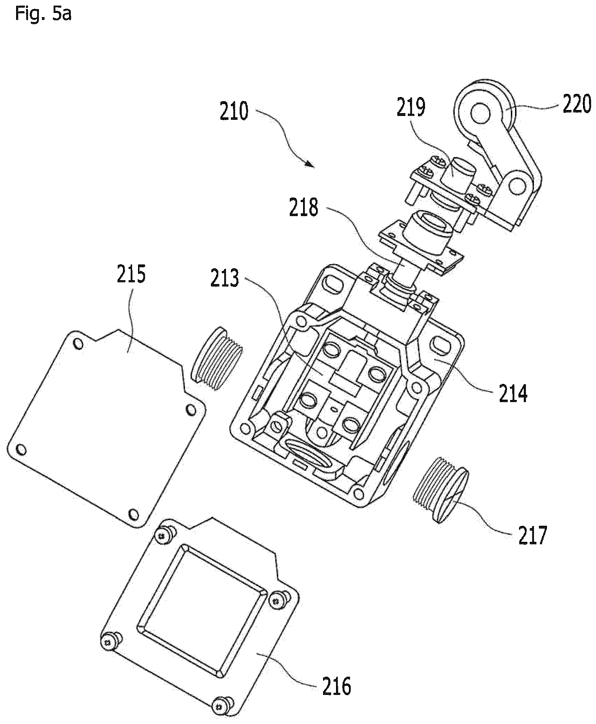

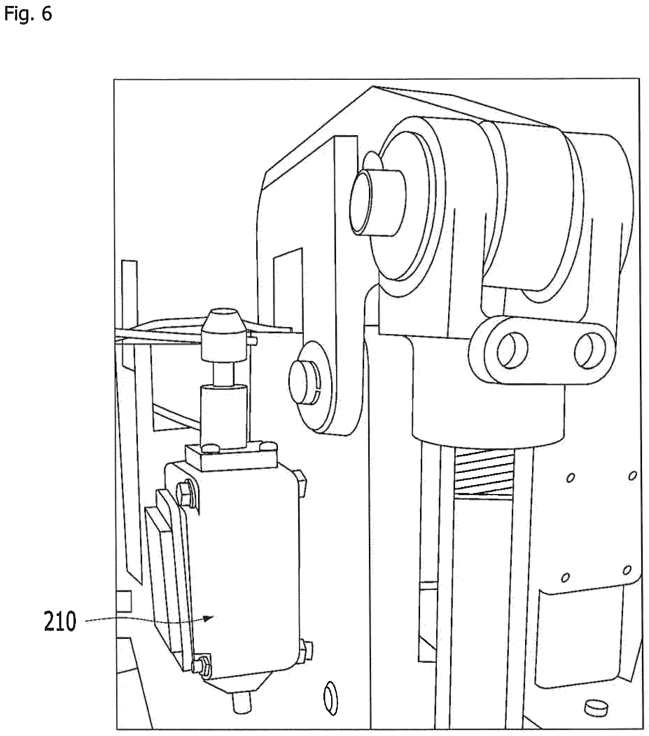

FIGS. 5A to 5C and 6 are views illustrating an example of a wireless limit sensor 210 of an industrial wireless sensor system 100 according to an embodiment of the present invention.

In some examples, the wireless limit sensor 210 may include a micro detection switch 211. A switching signal of the micro detection switch 211 by a push lever 212 may be input to the sensor controller 120.

As illustrated in FIG. 5A, in some examples, the wireless limit sensor 210 may include a base 214 on which a printed circuit board 213 is mounted, a seal 215, a cover 216, and screw plugs 217 to block the base 214, a putter 218, a button 219, and a roller 220 installed on an upper side of the base 214.

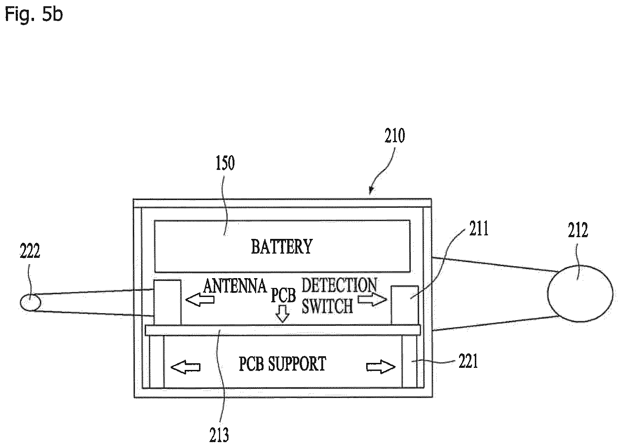

Further, as illustrated in FIG. 5B, the micro detection switch 211 may be mounted on the printed circuit board 213, and the printed circuit board 213 may be supported by a support 221. Further, the push lever 212 for switching the micro detection switch 211 may be installed on one side of the printed circuit board 213, and an antenna 222 for transmitting/receiving wireless signals may be installed on the other side of the printed circuit board 213. A battery 150 may be built in over the printed circuit board 213.

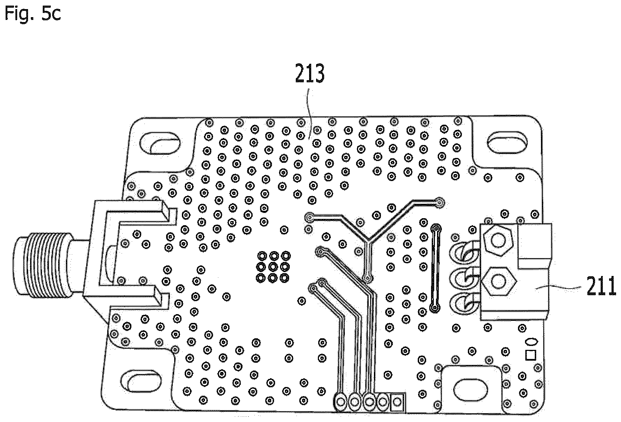

As illustrated in FIG. 5C, the micro detection switch 211 may be mounted on the lower surface of the printed circuit board 213.

In some instances, a panel may be seated on a jig, and the wireless limit sensor 210 may be attached to a side surface of a clamp supporting the panel as illustrated in FIG. 6. If the panel is placed on the jig, the panel presses the wireless limit sensor 210 so that the placement of the panel on the jig is sensed.

Meanwhile, the push lever 212 may be changed into various types, so that it may be used to detect a jig bogie moving to each process in an automated production line.

In some examples, the wireless limit sensor 210 may be installed on a bottom of a rail, and the bogie may be seated on the rail.

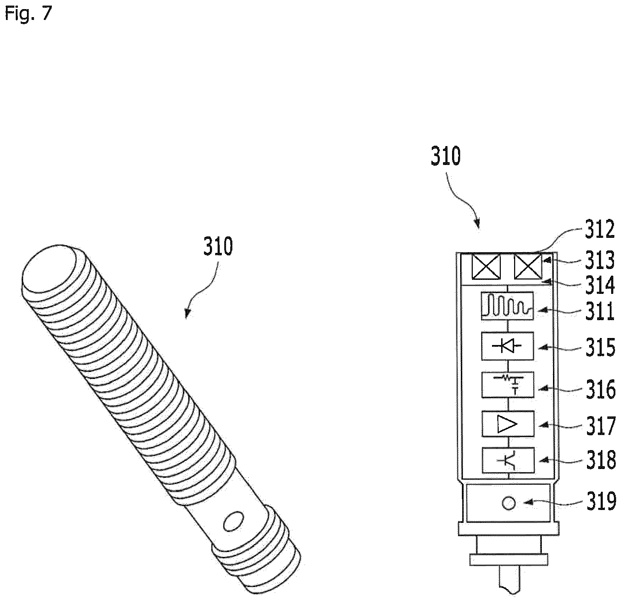

FIGS. 7, 8A, 8B, and 9 are views illustrating an example of a wireless proximity sensor 310 of an industrial wireless sensor system 100 according to an embodiment of the present invention.

In some examples, the wireless proximity sensor 310 may include a high frequency oscillation circuit 311. A signal of the high frequency oscillation circuit 311 caused by approach of a metallic object may be input to the sensor controller 120.

As illustrated in FIG. 7, the wireless proximity sensor 310 may include a detection surface 312, a coil 313, a core 314, an oscillation circuit 311, a rectification circuit 315, an integration circuit 316, an amplification circuit 317, an output circuit 318, and an operation indicator 319. In other words, the wireless proximity sensor 310 is an induction (high-frequency oscillation) type proximity sensor. The coil is positioned on the front surface and is connected in parallel with a capacitor to thereby configure an LC oscillator. The wireless proximity sensor 310 receives a frequency output from the LC oscillator, detects a change in frequency, and transmits data to the sensor controller 120 via SPI communication.

In other words, if a detection object (e.g., a metal) approaches a high-frequency magnetic field, which is generated around the core by high-frequency oscillation by the high-frequency oscillation circuit, an induced current is generated in the detection object due to electromagnetic induction. The induced current is generated in the direction of interfering with the change in the magnetic field generated around the detection coil, attenuating the amplitude of oscillation or stopping oscillation in the internal circuit. This is detected by the wireless proximity sensor 310, and the detected state, as data, is transmitted to the sensor controller 120 via SPI communication. The sensor controller 120 analyzes the data received through SPI communication and wirelessly transmits the presence or absence of detection to a factory controller through the wireless communication unit 130.

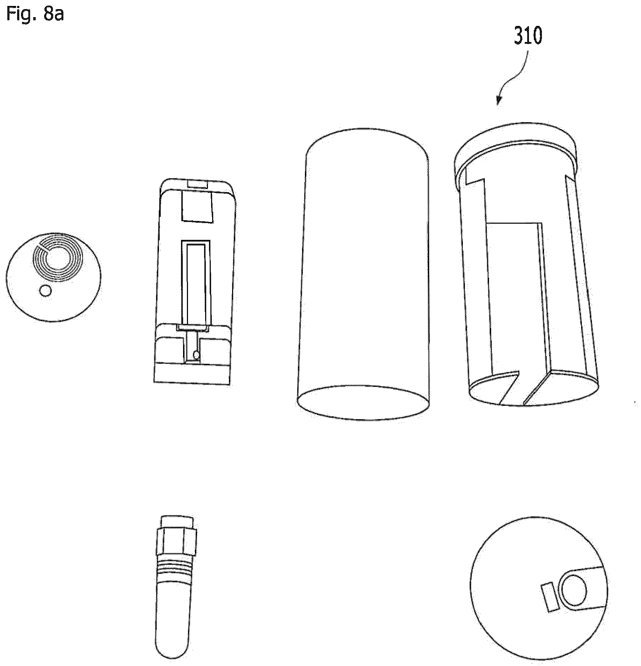

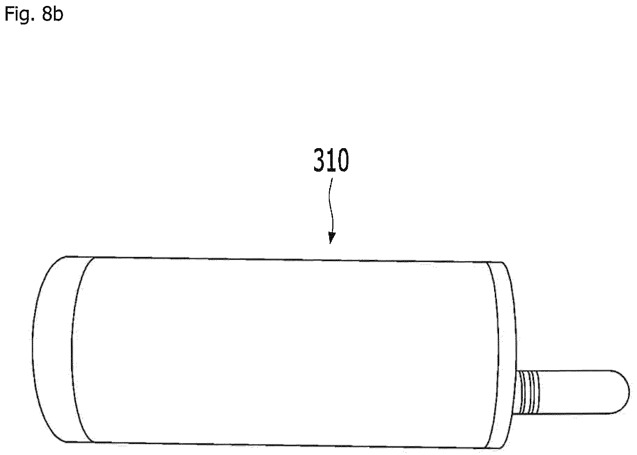

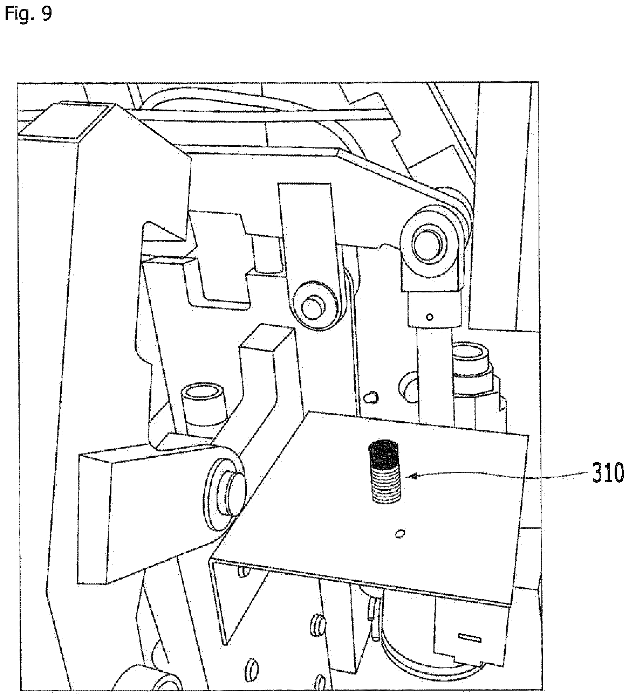

FIGS. 8A and 8B are views illustrating disassembly and assembly of the wireless proximity sensor 310 according to an embodiment of the present invention. FIG. 9 is a view illustrating a state in which the wireless proximity sensor 310 is attached to a side surface of a clamp. The wireless proximity sensor 310 is attached to a side surface of a clamp and, if a metal panel is placed, detects the panel and determines whether the panel is on the bogie.

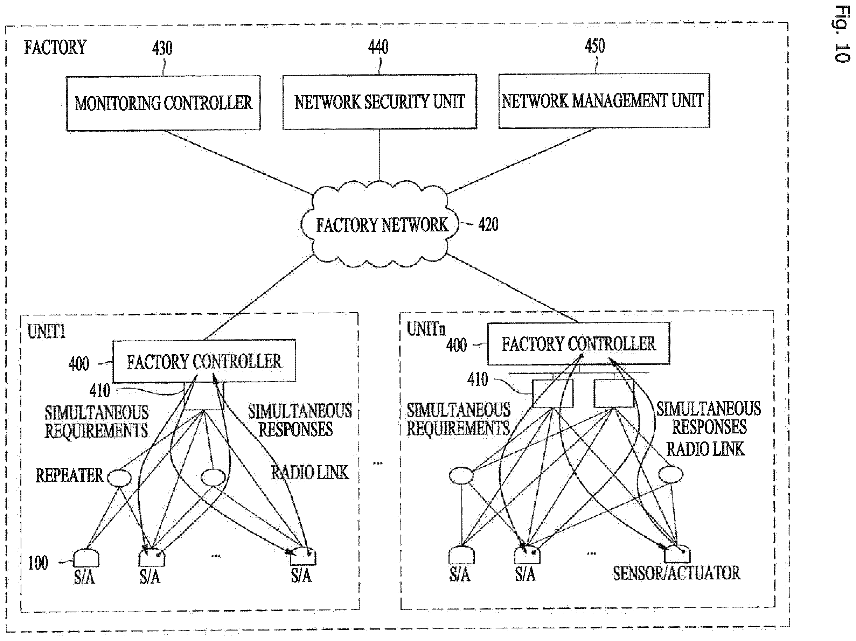

FIG. 10 is a block diagram illustrating a configuration of an industrial wireless sensor system 100 according to an embodiment of the present invention.

As illustrated in FIG. 10, the industrial wireless sensor system 100 according to an embodiment of the present invention may include a plurality of wireless sensors 100, 110, 210, and 310 having the above-described configuration in a factory, and the plurality of wireless sensors 110, 210, and 310 may be defined as one unit. Further, there may be provided a plurality of such units.

In some examples, a plurality of wireless sensors 110, 210, and 310 may be wirelessly connected to a factory controller 400. To that end, the factory controller 400 may include a wireless communication unit 410, and the wireless communication unit 410 may be connected to the wireless sensors 110, 210, and 310 through a repeater(s).

In some examples, each unit may include a factory controller 400 having a wireless communication unit 410 and a repeater. Further, each factory controller 400 may be wiredly or wirelessly connected to the factory network 420, and the factory network 420 may be wiredly or wirelessly connected with a monitoring controller 430, a network security unit 440, and/or a network management unit 450.

In this configuration, the factory controller 400 periodically transmits a command to the wireless sensors 100, 110, 210, and 310 (i.e., the sensor controller 120) of one unit that returns a response per cycle time.

Here, the cycle time is typically 2 ms to 20 ms to set a waiting time limit (1 ms to 10 ms), and the transmission needs to be made within this cycle time. Further, in this configuration, the factory controller 400 requests the sensor controller 120 to perform a sensing operation and, accordingly, the sensor controller 120 responds, that is, returns the sensing information.

After the wireless sensors 110, 210, and 310 of one unit complete initial access and registration and successfully receive necessary parameters, the factory controller 400 of the factory network 420 periodically sends a broadcast, multicast or unicast command to the wireless sensor controller 120 of the unit. The wireless sensor controller 120 returns a response (e.g., a sensing or acknowledgment response) within one cycle time. The probability that the cycle time may not be met should be <10⁻⁹. Further, the sensor controller 120 should simultaneously apply the commands received in the same cycle time (jitter < 10us).

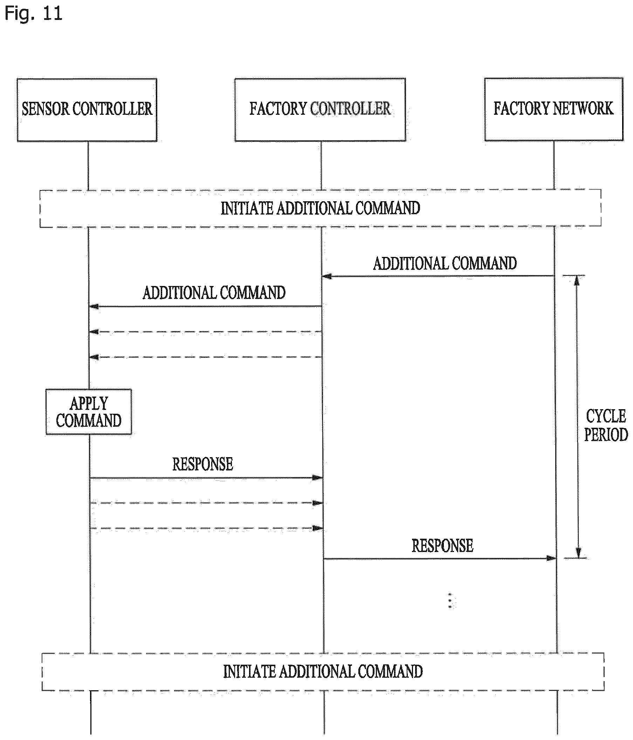

FIG. 11 is a view illustrating a wireless signal transmission/reception and cycle period between a sensor controller 120, a factory controller 400, and a factory network 420 in an industrial wireless sensor system 100 according to an embodiment of the present invention.

As illustrated in FIG. 11, after performing registration steps for the factory network 420, the start/stop of a periodic command is performed.
- Periodic command transmission; The sensor controller 120 of one unit should definitely receive the command from the factory controller 400 based on the received parameters. The other sensor controllers 120 need not receive or wake up. A diversity scheme (e.g., hybrid automatic repeat request (HARQ) retransmissions) may be applied to the transmissions. For example, HARQ retransmission may be performed when the wireless communication unit 410 of the factory controller 200 receives a certain HARQ NACK (negative acknowledgment). Only sensor controllers 120 that fail to receive the command need to receive a retransmission.
- Simultaneous command application; In one cycle time, the sensors 110, 210, and 310 of one unit should simultaneously apply the received commands.
- Transmission of response(s) to command; The sensor controller 120 of one unit should definitely send a response(s) to the factory controller 400 based on the received parameters. A diversity scheme (e.g., HARQ retransmissions) may be applied to the responses. For example, HARQ retransmission may be performed when one sensor controller 120 receives a certain HARQ NACK.

For periodic transmission of commands and obtaining responses within the cycle time, a scheduling configuration is required for providing radio resources for periodic transmission of commands from the factory controller 400 and relevant responses from the sensor controller 120 within the above-described cycle time.

In a radio access network, radio resource scheduling may be performed by the factory controller 400. However, commands are periodically transmitted from the factory network 420. The radio resource allocation of the factory controller 400 for downlink command transmission and uplink response needs to be well coordinated with the factory network 420 to meet the cycle time requirements described above. To that end, information needs to be considered that helps the factory controller 400 to properly configure the sensor controller 120 and provide radio resources to the sensor controller 120 to support periodic commands and/or responses from the sensor controller 120.

To that end, the factory controller 400 needs to know the time to start the transmission. Information related to the time to start transmission should be known to the factory controller 400. In some examples, one command may be included in the transmission. Such commands are periodically transmitted from the factory network 420. Further, the factory controller 400 needs to know the time to start the reception. Information related to the time to start reception should be known to the factory controller 400. In some examples, a response to the command may be included in the reception. In some examples, a response is transmitted from one sensor controller 120 to the factory controller 400.

In some examples, the above-described information may help the factory controller 400 to determine when to start a downlink transmission to the sensor controller 120 and provide the sensor controller 120 with a configuration for the downlink transmission. For example, an activation time and/or a start offset may be used to inform the sensor controller 120 of the time to start downlink reception. In a case where some responses (e.g., information for the sensor controller 120, status report, acknowledgment response or negative acknowledgment response) to the downlink transmission are required, the information may help the factory controller 400 to schedule uplink transmission for a response (e.g., time, message size, content) and provide a configuration for uplink transmission to the sensor controller 120. For example, the activation time and/or the start offset may be used to inform the sensor controller 120 of the time to start uplink transmission.

Embodiments of the present invention also provide a control processing method performed by the factory controller 400. The factory controller 400 receives information related to the times to perform periodic transmissions. The factory controller 400 may also receive information related to the times to perform periodic receptions. Based on the information, the factory controller 400 provides the sensor controller 120 with a configuration indicating periodic downlink resource allocation and periodic uplink resource allocation. The periodic downlink resource allocation and the periodic uplink resource allocation may be provided together in the same configuration or separately in different configurations.

The activation time and/or start offset may be expressed as a hyper frame number, a frame number, a subframe numbers or any combination thereof. Alternatively, the activation time and/or start offset may be expressed as a date, hours, minutes, seconds, milliseconds, microseconds, or any combination thereof. Such downlink reception and/or uplink transmission may be semi-persistent, such as semi-persistent scheduling (SPS), and that activation time and/or start offset may be used to indicate when the downlink and/or uplink SPS starts.

Further, additional information from the factory network 420 to the factory controller 400 may be considered which helps the factory controller 400 to properly configure the sensor controller 120 and provide radio resources to the sensor controller 120 to support periodic commands. Additional information from the factory controller 400 to the factory network 420 may also be considered. The information indicates a cycle time limit and also allows a certain sensor controller 120 to determine whether the sensor controller 120 belongs to the same group with the same group ID so that the factory controller 400 may reserve resources for the same group for periodic transmission and may help to transmit the above-described commands at correct times.

Multicast transmission is used for the same downlink command to handle the same command transmitted to one unit which may have two or more sensor controllers 120. When multicast is used, PDCCH resources and scheduling complexity may be reduced.

Lower layer signaling (e.g., PDCCH signaling) is not used for SPS activation or deactivation. Instead, dedicated RRC signaling is used to indicate the time to start SPS transmission/reception. All of the sensor controllers 120 in the one unit may equally understand when to start SPS transmission/reception and may prevent additional power consumption of an additional sensor controller 120 due to the initial SPS activation.

A configuration required for the sensor controller 120 and configurable exclusively for the sensor controller 120 may include, e.g., (1) a group RNTI (Radio Network Temporary Identifier), (2) a downlink and Uplink SPS interval, (3) a time to start downlink reception, (4) a time to stop downlink reception, (5) a time to start uplink transmission, (6) a time to stop uplink transmission, and (7) resource allocation for downlink reception and uplink transmission.

Further, the information known by the factory controller 400 may include (a) the sensor controller 120 of one unit receiving a command, (b) the arrival interval times of the commands, (c) an expression of the cycle time limit, (d) a time to start transmission of a command, and (e) the size of the command/size of the response.

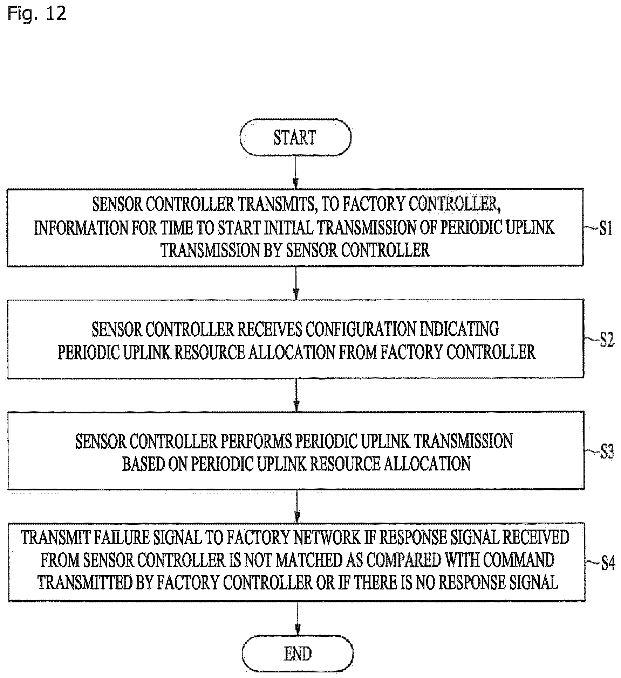

FIG. 12 is a flowchart illustrating a method for operating an industrial wireless sensor system 100 according to embodiments of the present invention.

First, the sensor controller 120 transmits time information for starting initial transmission of periodic uplink transmission by the sensor controller 120 to the factory controller 400 (S1). In other words, before the factory controller 400 receives the configuration from the sensor controller 120, the sensor controller 120 transmits "information indicating the time when the initial transmission of the periodic uplink transmission is started by the sensor controller 120" to the factory controller 400. In other words, in the factory automation system 100, to meet the cycle time requirement, information for the time when the initial uplink transmission from the sensor controller 120 to the factory controller 400 is started before the sensor controller 120 starts the uplink transmission is provided so that the factory controller 400 appropriately configures an uplink resource considering the information. This method is a different mechanism from the method for reconfiguring an already-active uplink SPS (SPS).

In other words, in the industrial wireless sensor system 100 according to the present invention, the "time to start the initial transmission of the periodic uplink transmission by the sensor controller 120" is directly provided, and a configuration is then set. Meanwhile, in some examples, the information may include an uplink transmission interval and an uplink transmission message size.

Subsequently, the sensor controller 120 receives a configuration indicating periodic uplink resource allocation from the factory controller 400 (S2).

Further, the sensor controller 120 transmits a periodic uplink to the factory controller 400 based on the periodic uplink resource allocation (S3).

Meanwhile, if the response signal received by the factory controller 400 from the sensor controller 120 is not matched as compared with the command transmitted to the sensor controller 120 (i.e., if not matched with a preset reference signal) or if no sensor (110, 210, or 310) response signal is received, the factory controller 400 transmits a sensor (110, 210, or 310) failure signal to the factory network 420 (S4). Therefore, the manager of the industrial wireless sensor system 100 may easily identify which of the plurality of units and/or the plurality of sensors 110, 210, and 310 fails through the monitoring controller 430, the network security unit 440, and/or the network management unit 450.

Further, according to the present invention, there is provided the industrial wireless sensor system 100 in which, for seamless transmission/reception of wireless signals within a cycle time in the factory automation system 100, information for the time when initial uplink transmission to the wireless communication unit 410 of the factory controller 400 is started before the wireless sensor 110, 210, or 310 starts uplink transmission is provided so that the factory controller 400 may appropriately configure an uplink resource considering the time information.

While the industrial wireless sensor system has been shown and described with reference to exemplary embodiments thereof, it will be apparent to those of ordinary skill in the art that various changes in form and detail may be made thereto without departing from the spirit and scope of the disclosure as defined by the following claims.

### *Legend of symbols*

- 100:: industrial wireless sensor system
- 110, 210, 310:: sensor
- 120:: sensor controller
- 130:: wireless communication unit
- 140:: power source
- 150:: battery

## Claims

1. An industrial wireless sensor system, comprising:
a sensor sensing an external physical state and outputting a sensing signal;
a sensor controller converting the sensing signal from the sensor, converting the sensing signal into a digital signal, and outputting the digital signal;
a wireless communication unit receiving the digital signal from the sensor controller,
converting the digital signal into a wireless signal, and outputting the wireless signal to a factory controller;
a power source supplying power to each of the sensor and the sensor controller; and
a battery connected to the power source.

2. The industrial wireless sensor system of claim 1, wherein the sensor includes at least one of a wireless magnetic field sensor, a wireless limit sensor, and a wireless proximity sensor.

3. The industrial wireless sensor system of claim 2, wherein the wireless magnetic field sensor includes a Hall sensor, and wherein an analog value of the Hall sensor is input to an analog-to-digital converter port of the sensor controller.

4. The industrial wireless sensor system of claim 3, wherein the wireless magnetic field sensor is attached to a cylinder.

5. The industrial wireless sensor system of claim 2, wherein the wireless limit sensor includes a micro detection switch, and wherein a switching signal of the micro detection switch by a push lever is input to the sensor controller.

6. The industrial wireless sensor system of claim 5, wherein the wireless limit sensor is attached to a jig on which a panel is seated or a rail on which a jig bogie moves.

7. The industrial wireless sensor system of claim 2, wherein the wireless proximity sensor includes a high frequency oscillation circuit, and wherein a signal from the high frequency oscillation circuit by approach of a metallic object is input to the sensor controller.

8. The industrial wireless sensor system of claim 7, wherein the wireless proximity sensor is attached to a clamp on which a panel is seated.

9. The industrial wireless sensor system of claim 1, wherein the industrial wireless sensor system performs:
a step in which the sensor controller transmits, to the factory controller, information for a time to start initial transmission of periodic uplink transmission by the sensor controller;
a step in which the sensor controller receives a configuration indicating periodic uplink resource allocation from the factory controller;
a step in which the sensor controller transmits a periodic uplink to the factory controller based on the periodic uplink resource allocation; and
a step of transmitting a sensor failure signal to a factory network if a response signal received by the factory controller from the sensor controller is not matched as compared with a command transmitted to the sensor controller by the factory controller or if no response signal is received.
